# EUROPEAN PATENT SPECIFICATION

(11) **EP 0 543 881 B1**
(45) Date of publication and mention of the grant of the patent: **28.06.1995**
(21) Application number: 91914705.8
(22) Date of filing: 07.08.1991
(51) Int. Cl.: G03C 1/91, G03F 7/038, B41M 5/38

(54) **SINGLE LAYER DRY PROCESSIBLE PHOTOSENSITIVE COMPOSITION AND TONING PROCESS**
EINSCHICHT-TROCKENE LICHTEMPFINDLICHE ZUSAMMENSETZUNG FÜR BEHANDLUNG UND ANSTRICHVERFAHREN
COMPOSITION PHOTOSENSIBLE UNICOUCHE POUVANT ETRE TRAITEE ET PROCEDE DE VIRAGE

(30) Priority: 08.08.1990 US 564246
(43) Date of publication of application: 02.06.1993
(73) Proprietor: E.I. DU PONT DE NEMOURS AND COMPANY, Wilmington Delaware 19898 (US)
(72) Inventor: HERTLER, Walter, Raymond, Kennett Square, PA 19348 (US)
(74) Representative: von Kreisler, Alek, Dipl.-Chem.
(86) International application number: US9105502
(87) International publication number: WO9202855

(56) References cited:
- EP-A- 0 302 359
- EP-A- 0 440 444
- US-A- 4 294 909
- US-A- 4 853 364

## Description

### FIELD OF THE INVENTION

The use of light to cause imagewise formation of tackiness in a film is known as phototackification. The image produced in the light-struck areas can be read out by applying toner particles to the surface. The toner particles selectively adhere to the tacky regions on a surface, thus providing the basis for negative-working color materials for the graphic arts industries. Examples of materials that directly result in tackiness upon irradiation are rare. Most negative working systems require a separate wet development step. The present invention produces a tacky surface by using a process dependent upon the ability of a miscible polymer blend to undergo a photochemical change that results in a microphase separation of a tacky polymer from a non-tacky polymer and does not require a separate wet development step.

The present invention concerns a phototackifiable composition useful as a coating on a substrate consisting of an optically clear blend of two or more polymers one or more of which is capable of undergoing an acid catalyzed chemical reaction and a photosensitive compound that forms a strong acid on exposure to actinic radiation. The invention also relates to a process for coating such a composition on a support and toning the image-wise exposed composition on the support. The compositions described herein are useful in the graphic arts area in the production of negative images, including use as coatings for negative working tonable photosensitive elements, in color separations, and in making multicolor images from masters.

### BACKGROUND ART

Photosensitive elements are used as reproduction means in a variety of fields involving photographic reproduction. The present invention bases its reproduction capabilities on the differences in adhesive qualities between imagewise exposed and unexposed image areas.

U.S. 4,356,252 teaches a photosensitive element useful for making color proofs comprising a support bearing a layer of negative-working tonable photoimageing composition comprising at least one organic polymeric binder, a photosensitizer which forms an acid upon exposure to actinic radiation, and at least one acetal compound wherein the polymeric binder is plasticized. U.S. 4,294,909 teaches a process for preparing negative tonable images comprising exposing imagewise a photosensitive element bearing a layer of negative-working tonable image composition as in U.S. 4,356,252. The principle involved in U.S. 4,356,252 and U.S. 4,294,909 is that the photogenerated acid decomposes the (solid) nonpolymeric acetal compound(s) and the resulting liquid products plasticize the binder so that T_{g} is lowered and the binder becomes tacky enough to be toned. These patents differ from the present invention which achieves its tackiness as the result of a tacky polymer layer present in the composition, which is masked by the presence of a nontacky polymer that is miscible with the tacky polymer. Upon exposure to acid which is generated by exposure of the element to actinic radiation, the tackiness of the tacky polymer is "unmasked".

U.S. 4,263,385 discloses a tonable phototackifiable system based on photodegradation of a poly(acetylene sulfone).

U.S. 4,876,172 discloses phototackifiable particles based on the irradiation of a photoacid generator with resulting depolymerization of acid-labile poly(phthalaldehyde).

U.S. 3,563,738 discloses a reproduction material which combines a first tacky component and a light sensitive component which upon exposure to actinic radiation, changes the heat-activatability and thermal properties of the first component.

U.S. 4,683,190 discloses a process for lowering the viscosity of coating solutions containing a thixotropy-causing filler for the production of light-sensitive reproduction materials.

U.S. 4,346,162 discloses a nonsilver reproduction element for preparing negative tonable images which comprises a support bearing a layer of photosensitive composition comprising at least one thermoplastic binder and at least one thio compound.

GB Patent No. 1,429,082 discloses a method for forming an image by utilizing tackiness of a layer of deteriorative-type natural or synthetic rubber induced by exposure to actinic radiation. The tackiness was induced by image-wise exposing of the layer of the rubber.

GB 2,111,233 B discloses a method of forming a cathode-ray phosphor screen, particularly a method for causing particles to adhere to the sticky surface. A photosensitive composition is exposed to ultraviolet light through a shadow-mask and becomes sticky. Phosphor particles are stuck on a portion of the upward facing sticky surface.

EPA No. 0 303 266 discloses dry nonelectroscopic toners and process for their use comprising pigmented organic resins treated with an organofunctional substituted fluorocarbon compound and their use in toning photosensitive elements having tacky areas.

DE 3806515 C1 discloses a process for the manufacture of metal powders for use as toners of adhesive patterns on ceramic substrates.

### SUMMARY OF THE INVENTION

It is an object of the present invention to provide a phototackifiable composition that can result in a tacky polymer upon irradiation.

It is another object of the present invention to provide a phototackifiable composition that can result in a tacky polymer upon irradiation without the need for a separate wet development step.

It is a further object of this invention to provide a process for creating tackiness as a result of changes in the miscibility of polymer phases.

In accord with the above objects, this invention provides a coating composition for use on a substrate comprising an optically clear blend of two or more polymers with a photosensitive compound that forms a strong acid upon image-wise exposure to actinic radiation, characterized in that the composition of the blend comprises:
(a) at least one first polymer that is tacky as a result of having a glass transition temperature T_{g} of below room temperature;
(b) at least one second polymer that has a T_{g} sufficiently far above room temperature so that the blend of first and second polymer(s) is not tacky at room temperature;
(c) a component that generates an acid upon exposure to actinic radiation; and that
(d) said second polymer(s) has(have) functional groups that are sensitive to catalytic amounts of an acid, such that the reaction of functional groups in the presence of the acid results in a polymer with carboxylic acid groups or phenolic groups, said resulting polymer being immiscible with the tacky polymer in the blend.

In order for the invention to be operable, the low Tg tacky polymer(s) must be sufficiently soluble in the higher T_{g}, acid labile polymer(s), in some proportion, so that an optically clear, non-tacky coating can be obtained.

The invention also concerns a substrate coated with the above composition and a process for using said composition on a support and a process for toning the supported composition.

### DETAILED DESCRIPTION OF THE INVENTION

This invention consists of a coating (on a substrate, preferably polyester film e.g., Mylar®) of an optically clear blend of two or more polymers (at least one polymer with a low glass transition temperature T_{g}), below room temperature, and a second with a high T_{g} and a photosensitive compound, that yields a strong acid on image-wise exposure to actinic radiation.

It has been found that certain polymers of low T_{g} are tacky and polymers of high T_{g} with pendant acid labile groups are non-tacky. By blending the two, a non-tacky optically clear film can be prepared. If a source of photo-generated acid is present in the film (typically approximately 2%), it has been found that the acid will react with the polymer of high Tg, causing it not to be miscible with the tacky polymer of low Tg. It is thought that surface tackiness occurs because the tacky low T_{g} material migrates to the surface of the film. The surface is thus provided with a material that can selectively attract toner particles.

Examples of polymers having low T_{g}, i.e below room temperature are poly(2-phenylethyl acrylate) (PPEA) and poly(3-phenyl-1-propyl acrylate) (PPPA). The low T_{g} polymer must be sufficiently miscible with the higher T_{g}, acid labile polymer(s), so that an optically clear, non-tacky coating is obtained. The tacky (co)polymers having Tg below room temperature may be prepared by any known polymerization method, for example addition polymerization, condensation polymerization or ring opening polymerization and must be soluble to some extent in the acid labile polymers so that an optically clear coating of the polymer blend can be obtained. The proportion of polymers in the blend are adjusted so that the blend is maintained tack-free and optically clear at ambient temperature. For example, a tertiary blend of 25% poly(tetrahydro-2-pyranyl methacrylate) (PTHPMA), 25% poly(tetrahydro-2-pyranyl acrylate) (PTHPA) and 50% tacky poly(2-phenylethyl acrylate) (PPEA) gives a non-tacky optically clear film at ambient temperature. In the presence of a photogenerated strong acid, PTHPMA and PTHPA form poly(methacrylic acid) and poly(acrylic) acid, respectively, which are not miscible with tacky PPEA. The tacky PPEA forms a-separate phase and is able to attract toner particles.

Typically, the T_{g} of the blend is higher than that of the tacky polymer and lower than that of the acid-labile polymer.

It is preferred that the molecular weight of the tacky polymer(s) be less than 30,000 g/mol.

The acid labile group of the high T_{g}, acid labile, polymer is an acetal ester, t-butyl ester, t-butoxy-carbonyloxy derivative of a phenol, or an acetal ether of a phenol. It is preferred that the molecular weight of the acid-labile (co)polymer(s) be less than about 30,000 g/mol.

The acid generating component of the composition of this invention is a substance that forms an acid upon exposure to actinic radiation. When activated by actinic radiation, the acid generating component furnishes the acid that catalyzes decomposition of the acid labile groups in the polymeric material. Examples of compounds and mixtures which can be used as acid sources include diazonium, phosphonium, sulfonium, and iodonium salts (generally present in the form of salts with complex metal halide ions such as tetrafluoroborate, hexafluoroantimonate, hexafluoroarsenate, and hexafluorophosphate); halogen compounds; o-quinone diazide sulfochlorides; organometal/organohalogen combinations; o-nitrobenzyl esters of strong acids, e.g., toluene sulfonic acid; N-hydroxy amide and imide sulfonates; and, preferably, diphenyl-3-(9-anthryl)-1-propylsulfonium hexafluoroantimonate.

It may be desirable to add a sensitizer to the system to adjust the spectral sensitivity to the available wavelength of the actinic radiation. The need will depend on the requirements of the system and the specific photosensitive acid generator employed. For instance photosensitive acid generators that respond to wavelengths below 300 nm may be sensitized to longer wavelengths by inclusion of polycyclic aromatic hydrocarbon sensitizers such as perylene, pyrene and anthracene.

The time required for development of tackiness following exposure to actinic radiation will vary depending upon the composition of the coating. Depending upon the acid strength or the nature of the acid labile functional group, it may be necessary to heat the coating after exposure to induce tackification.

The coatings of the photosensitive polymer blends described herein may be prepared by any standard technique including roller coating, drawdown of a solution, extrusion or by spincoating a solution.

The photosensitive composition described above may be applied to various support materials including, but not limited to paper, cardboard, metal sheets, wood, glass, and films or fiber webs of natural or synthetic polymers. The support may be transparent or opaque. The coating may be applied with or without a top coating of protective film to protect the photosensitive coating. It is also possible to include additional nonphotosensitive layers or components, e.g., an antihalation layer, or antihalation ingredient(s). The antihalation layer would be beneath the photosensitive layer, or there could be antihalation compounds included within the coating.

The components of the photosensitive layer are applied to the support either as a solution in volatile solvents or without the use of solvents. Solvents for use on supports include 2-butanone, acetone, methylene chloride, tetrahydrofuran, and ethyl acetate. Applications for which no solvent is required include calendering and extruding. Upon exposure to actinic radiation, the acid liberated by the light rapidly converts the acid labile polymers to carboxylic acid or phenolic polymers which are not miscible with the tacky polymer. When microseparation of the phases occurs, it is believed that the tacky phase may migrate to the surface of the film in the exposed areas creating a surface that can be toned.

The concentration of the nonvolatile components of the coating solution can fluctuate within broad limits, but is dependent on the coating method and the thickness desired for the different purposes of application.

To tone the image-wise exposed photosensitive layer, powdered dyes and/or pigments of many different types can be used. For example, inorganic or organic pigments are suitable as are soluble organic dyes. The individual dye particles can be provided with a protective layer of a suitable polymeric material for the purpose of improving handling. Suitable toners are described, for example, in U.S. Pat. Nos. 3,060,024, 3,620,7 26, and 3,909,282.

The toning procedure is either implemented manually, e.g., by means of a cotton pad, or a special application device. The image can, in this case, be produced directly on the support, which carries the photosensitive layer. If desired, the toned image can be transferred also to another material by lamination. According to another embodiment, the photosensitive layer is transferred to the final support prior to exposure and there exposed and toned. Depending on the selection of support material, non-transparent as well as transparent images can be produced. For the production of multicolored images several images toned in the individual colors are coated or laminated over each other.

Exposure of the photosensitive layer is accomplished by using radiation furnishing sources. Ultraviolet sources include carbon arcs, mercury vapor arcs, fluorescent lamps with special ultraviolet-emitting phosphors, argon glow lamps, electronic flash units and photographic flood lamps. Direct writing with suitable lasers is also useful. The amount of exposure required for satisfactory reproduction is a function of the nature and concentration of photoacid generator and optional sensitizers in the photosensitive layer, type of radiation source used, and distance between the radiation source and layer surface. In general, exposure times range from 4 seconds to 2 minutes using standard commercial radiation sources.

### EXAMPLES

### EXAMPLE 1

### Phototackification of Coating of a 50:35:15 Blend of Poly(2-phenylethyl acrylate), Poly(tetrahydro-2-pyranyl methacrylate), and poly(tetrahydro-2-pyranyl acrylate).

A solution was prepared by dissolving 1.96 g of poly(2-phenylethyl acrylate) [Mₙ = 15,200, M_{w} = 25,900, M_{w}/Mₙ = 1.64], 1.4 g of poly(tetrahydro-2-pyranyl methacrylate) [Mₙ = 6570, M_{w} = 8650, M_{w}/Mₙ = 1.32], 0.6 g of poly(tetrahydro-2-pyranyl acrylate) [Mₙ = 19,500, M_{w} = 33,700, M_{w}/Mₙ = 1.73], and 0.08 g of diphenyl-3-(9-anthryl)-1-propylsulfonium hexafluoroantimonate ("DPAS") in 17.64 g of 2-butanone. The solution was concentrated to 50% solids and coated on 0.18 mm (7 mil) Mylar® polyester film with a 0.025 mm (1 mil) doctor blade. After drying, the coatings were exposed through a Stouffer neutral density step wedge (Stouffer Graphic Arts Equipment Co., South Bend, IN 46617) to 50, 100, 200, and 400 mj/cm² integrated between 300 and 400 nm) using a Du Pont PC 130 printer containing a 5000 W high pressure mercury lamp. Immediately following the exposure no tackiness was apparent, and no toning occured with black toner. After storing for 2.5 days in the dark, the coatings had become tacky in the areas exposed to light, and application of black toner to the film exposed to 50 mj/cm² led to full toning of the first 13 steps (corresponding to a density of 0.65). Unexposed areas remained clear and transparent. With the film exposed to 200 mj/cm² 32 steps were toned (corresponding to a density of 1.56). Differential scanning calorimetry (DSC) of a sample of coating material similarly exposed to 400 mj/cm² showed a Tg of 1°C, with a second possible Tg at 199°C. There was no endotherm below 200°C, which indicates that there were no remaining tetrahydropyranyl ester groups in the polymer. DSC of a similar coating which contained no DPAS, and which was not exposed to light, showed a Tg of 9.8°C.

### EXAMPLE 2

### Phototackifiction of Coating of a 2:1:1 Blend of Poly(2-phenylethyl acrylate), Poly(tetrahydro-2-pyranyl methacrylate), and poly(tetrahydro-2-pyranyl acrylate).

A 50% solids solution of 0.49 g of poly(2-phenylethyl acrylate) [Mₙ = 15,500,M_{w} = 24,700, M_{w}/Mₙ = 1.6, Tg = 2°C], 0.245 g of poly(tetrahydro-2-pyranyl methacrylate)Mₙ = 6570, M_{w} = 8650, M_{w}/Mₙ = 1.32], 0.245 g of poly(tetrahydro-2-pyranyl acrylate) [Mₙ = 19,500, M_{w} = 33,700, M_{w}/Mₙ = 1.73], and 0.02 of DPAS in 2-butanone was coated on 0.18 mm (7 mil) Mylar® polyester film with a 0.025 mm (1 mil) doctor blade, and dried. The coating was exposed through a UGRA Plate Control Wedge 1982 (containing concentric circles spaced from 4 to 70 »m, a continuous tone wedge, and highlight and shadow half tone dot control patches) to 100mj/cm² with the light source of Example 1. Upon removal of the film from the exposure device, haze and tackiness was observed in the light-struck areas. When the image was rubbed with black toner, toner adhered to the light-struck areas providing a negative image. Four steps were toned corresponding to a sensitivity of 25 mj/cm². Dot-retention was from 2% to 97% dots. Resolution of line and spaces was 6 »m.

### EXAMPLE 3

### Phototackification of Coating of a 2:1:1 Blend of Poly(2-phenylethyl acrylate), Poly(tetrahydro-2-pyranyl methacrylate), and poly(tetrahydro-2-pyranyl acrylate) with Commercial Photoacid Generator.

In the composition of Example 2, the DPAS was replaced with 0.06 g of Union Carbide UVI 6974 (a 50% solution of mixed salts of triarylsulfonium hexafluoroantimonate). The coatings were covered with a 0.025 mm (1 mil) Mylar® polyester film to prevent photoadhesion to the photomask. The coatings were then exposed through the UGRA wedge of Example 2 to 100 and 200 mj/cm² with the light source of Example 2. The 1 mil Mylar® protective sheet was removed after cooling to-78°C. After warming to room temperature (29°C), the coatings were examined for tackiness and haze. The coating which had been exposed to 100 mj/cm² showed haze in the light-struck areas, but was not tacky enough to accept toner. The coating which had been exposed to 200 mj/cm² showed image-wise haziness, and could be toned. The resulting toned negative image showed no steps. Dot-retention was from 50% to 2% dots. Control coatings with the composition of Example 2 (containing DPAS) similarly exposed through 0.025 mm (1 mil) Mylar® cover sheets were toned. The coating exposed to 100 mj/cm² showed 7 steps (corresponding to a sensitivity of 9 mj/cm²), 10% to 96% dot-retention, and 6» lines and spaces. The coating exposed to 200 mj/cm² showed 9 steps (corresponding to a sensitivity of 9 mj/cm²), 20% to 98% dot retention, and 6» lines and spaces.

### EXPERIMENT A

### Preparation of Poly(3-phenyl-1-propyl acrylate)

To a stirred solution of 50.4 g (50 mℓ, 0.37 mol) of 3-phenyl-1-propanol and 40.9 g (57 mℓ, 0.404 mol) of triethylamine in 350 mℓ of dichloromethane cooled in an ice-water bath was added 35.6 g (32 mℓ, 0.393 mol) of acrylyl chloride at a rate such that the temperature did not exceed 24°C. The mixture was stirred for 15 minutes at room temperature, and a small amount of phenothiazine was added. Then 5 mℓ of water was added, and the mixture was stirred for 30 minutes. The mixture was washed successively with 3% hydrochloric acid, water, 5% sodium bicarbonate solution, and water. The organic layer was dried over magnesium sulfate, and the solvent was removed under reduced pressure to give 58.64 g of 3-phenyl-1-propyl acrylate.

A solution of 58.64 g (0.308 mol) of 3-phenyl-1-propyl acrylate and 0.2 g of azobis(isobutyronitrile) in 450 mℓ of degassed ethyl acetate was heated at reflux for 5 hours. Then 0.2 g of azobis(isobutyronitrile) was added, and refluxing was continued for 5 hours. After a final treatment with 0.2 g of azobis(isobutyronitrile) followed by 5 hours of reflux, NMR analysis showed 14% residual monomer. The product was precipitated in methanol and reprecipitated four times from dichloromethane with methanol to give 29 g of poly(3-phenyl-1-propyl acrylate) as a tacky gum. Differential scanning calorimetry showed a T_{g} of -11.7°C. Gel Permeation Chromatography shows Mₙ = 8420, M_{w} = 13,900, M_{w}/Mₙ = 1.65.

### EXAMPLE 4

### Phototackification of Coating of a 2:1:1 Blend of Poly(3-phenyl-1-propyl acrylate, Poly(tetrahydro-2-pyranyl acrylate) and Poly(tetrahydro-2-pyranyl methacrylate)

In the composition and procedure of Example 2, the 0.49 g of poly(2-phenylethyl acrylate) was replaced with 0.49 g of poly(3 pheny-1-propyl acrylate). Exposure to 100 mj/cm² resulted in a tacky image which accepted toner well to produce a toned negative image with greater optical density than in Example 2. The 100 mj/cm² exposure resulted in toning of 8 of the neutral density steps corresponding to a sensitivity to 6 mj/cm². This exposure reproduced the 98% holes, and the 4 » lines/spaces.

Although preferred embodiments of the invention have been described hereinabove, it is to be understood that there is no intention to limit the invention to the precise constructions herein disclosed, and it is to be further understood that the right is reserved to all changes coming within the scope of the invention as defined by the appended claims.

## Claims

1. A coating composition for use on a substrate comprising an optically clear blend of two or more polymers with a photosensitive compound that forms a strong acid upon image-wise exposure to actinic radiation, characterized in that the composition of the blend comprises:
(a) at least one first polymer that is tacky as a result of having a glass transition temperature T_{g} of below room temperature;
(b) at least one second polymer that has a T_{g} sufficiently far above room temperature so that the blend of first and second polymer(s) is not tacky at room temperature;
(c) a component that generates an acid upon exposure to actinic radiation; and that
(d) said second polymer(s) has (have) functional groups that are sensitive to catalytic amounts of an acid, such that the reaction of functional groups in the presence of the acid results in a polymer with carboxylic acid groups or phenolic groups, said resulting polymer being immiscible with the tacky polymer in the blend.

2. The composition of claim 1 wherein the tacky first polymer is poly(2-phenylethyl acrylate) or poly(3-phenyl-1-propyl acrylate).

3. The composition of claim 2 wherein the tacky first polymer is poly(2-phenylethyl acrylate).

4. The composition of claim 2 wherein the tacky first polymer is poly(3-phenyl-1-propyl acrylate).

5. The composition of claim 1 wherein the molecular weight of the tacky first polymer(s) is less than 30,000 g/mol.

6. The composition of claim 1 wherein the acid labile group of the high T_{g} second polymer(s) is selected from an acetal ester, t-butyl ester, a t-butoxycarbonyloxy derivative of a phenol, and an acetal ether of a phenol.

7. A composition according to claim 1 wherein the acid labile second polymer(s) is(are) selected from poly(tetrahydro-2-pyranyl methacrylate) and poly(tetrahydro-2-pyranyl acrylate).

8. The composition of claim 1 wherein the molecular weight of the acid labile second polymer(s) is less than 30,000 g/mol.

9. The composition of claim 1 in which the polymers are prepared by a method selected from addition polymerization, condensation polymerization, and ring opening polymerization.

10. The composition of claim 1 wherein the T_{g} of the blend is higher than that of the tacky first polymer(s) and lower than that of the acid labile second polymer(s).

11. A composition according to claim 1 wherein the acid generating component is selected from diazonium, phosphonium, sulfonium, and iodonium salts, halogen compounds, o-quinone diazide sulfochlorides, organometal/organohalogen combinations, and o-nitro-benzyl esters of strong acids.

12. A composition according to claim 1 wherein the acid generating component is diphenyl-3-(9-anthryl)-1-propyl-sulfonium hexafluoroantimonate.

13. The composition of claim 1 in a solvent selected from 2-butanone, acetone, methylene chloride, tetrahydrofuran and ethyl acetate.

14. A radiation sensitive element comprising a support bearing a layer of a composition according to any one of claims 1 to 12.

15. The element of claim 14 wherein the support is elected from paper, cardboard, metal sheets, wood, glass, films or fiber webs of natural polymers and films or fiber webs of synthetic polymers.

16. The element of claim 14 wherein an additional non-photosensitive layer is applied to the support.

17. The element of claim 14 wherein the additional non-photosensitive layer is an antihalation coating located beneath the photosensitive layer.

18. A process for creating a tonable surface comprising the step of irradiating an element in accordance with any one of claims 14 to 17 to form acid which results in the tacky tonable surface.

19. The process of claim 18 wherein the tacky tonable surface is toned with toner particles which adhere to the tacky surface.

## Patentansprüche

1. Beschichtungszusammensetzung zur Verwendung auf einem Substrat, umfassend ein optisch durchsichtiges Gemisch von zwei oder mehr Polymeren mit einer lichtempfindlichen Verbindung, die bei bildweiser Belichtung mit aktinischer Strahlung eine starke Säure bildet, dadurch gekennzeichnet, daß die Zusammensetzung des Gemischs folgendes umfaßt:
(a) wenigstens ein erstes Polymer, das klebrig ist, weil es eine Glasübergangstemperatur T_{g} unterhalb Raumtemperatur besitzt;
(b) wenigstens ein zweites Polymer, das ein T_{g} ausreichend weit oberhalb Raumtemperatur besitzt, so daß das Gemisch aus dem (den) ersten und dem (den) zweiten Polymer(en) bei Raumtemperatur nicht klebrig ist;
(c) eine Komponente, die bei Belichtung mit aktinischer Strahlung eine Säure erzeugt; und daß
(d) das (die) zweite(n) Polymer(e) funktionelle Gruppen hat (haben), die empfindlich gegenüber katalytischen Mengen einer Säure sind, so daß die Reaktion funktioneller Gruppen in Gegenwart der Säure ein Polymer mit Carbonsäuregruppen oder Phenolgruppen ergibt, wobei das resultierende Polymer mit dem klebrigen Polymer in dem Gemisch nicht mischbar ist.

2. Zusammensetzung gemäß Anspruch 1, wobei es sich bei dem klebrigen ersten Polymer um Poly-2-phenylethylacrylat oder Poly-3-phenyl-1-propylacrylat handelt.

3. Zusammensetzung gemäß Anspruch 2, wobei es sich bei dem klebrigen ersten Polymer um Poly-2-phenylethylacrylat handelt.

4. Zusammensetzung gemäß Anspruch 2, wobei es sich bei dem klebrigen ersten Polymer um Poly-3-phenyl-1-propylacrylat handelt.

5. Zusammensetzung gemäß Anspruch 1, wobei das Molekulargewicht des (der) klebrigen ersten Polymers (Polymere) kleiner als 30000 g/mol ist.

6. Zusammensetzung gemäß Anspruch 1, wobei die säurelabile Gruppe des (der) zweiten Polymers (Polymere) mit dem hohen T_{g} aus einem Acetalester, t-Butylester, t-Butoxycarbonyl oxyderivat eines Phenols und einem Acetalether eines Phenols ausgewählt ist.

7. Zusammensetzung gemäß Anspruch 1, wobei das (die) säurelabile(n) zweite(n) Polymer(e) aus Polytetrahydro-2-pyranylmethacrylat und Polytetrahydro-2-pyranylacrylat ausgewählt ist (sind).

8. Zusammensetzung gemäß Anspruch 1, wobei das Molekulargewicht des (der) säurelabilen zweiten Polymers (Polymere) kleiner als 30000 g/mol ist.

9. Zusammensetzung gemäß Anspruch 1, wobei die Polymere nach einem Verfahren hergestellt sind, das aus Additionspolymerisation, Kondensationspolymerisation und Ringöffnungspolymerisation ausgewählt wurde.

10. Zusammensetzung gemäß Anspruch 1, wobei der T_{g}-Wert des Gemischs höher als der des (der) klebrigen ersten Polymers (Polymere) und niedriger als der des (der) säurelabilen zweiten Polymers (Polymere) ist.

11. Zusammensetzung gemäß Anspruch 1, wobei die säurebildende Komponente aus Diazonium-, Phosphonium-, Sulfonium- und Iodoniumsalzen, Halogenverbindungen, o-Chinondiazidsulfochloriden, Kombinationen aus metallorganischen und halogenhaltigen organischen Verbindungen und o-Nitrobenzylestern starker Säuren ausgewählt ist.

12. Zusammensetzung gemäß Anspruch 1, wobei es sich bei der säurebildenden Komponente um Diphenyl-3-(9-anthryl)-1-propylsulfoniumhexafluoroantimonat handelt.

13. Zusammensetzung gemäß Anspruch 1 in einem Lösungsmittel, das aus 2-Butanon, Aceton, Methylenchlorid, Tetrahydrofuran und Ethylacetat ausgewählt wird.

14. Strahlungsempfindliches Element, das einen Träger umfaßt, der eine Schicht aus einer Zusammensetzung gemäß einem der Ansprüche 1 bis 12 trägt.

15. Element gemäß Anspruch 14, wobei der Träger aus Papier, Pappe, Metallblechen, Holz, Glas, Filmen oder Fasergeweben natürlicher Polymere und Filmen oder Fasergeweben synthetischer Polymere ausgewählt ist.

16. Element gemäß Anspruch 14, wobei eine zusätzliche nichtlichtempfindliche Schicht auf den Träger aufgetragen wird.

17. Element gemäß Anspruch 14, wobei die zusätzliche nichtlichtempfindliche Schicht eine Lichthofschutzbeschichtung ist, die sich unter der lichtempfindlichen Schicht befindet.

18. Verfahren zur Erzeugung einer tonbaren Oberfläche, das den Schritt des Bestrahlens eines Elements gemäß einer der Ansprüche 14 bis 17 unter Bildung einer Säure umfaßt, was die klebrige tonbare Oberfläche ergibt.

19. Verfahren gemäß Anspruch 18, wobei die klebrige tonbare Oberfläche mit Tonerteilchen getont wird, die an der klebrigen Oberfläche haften.

## Revendications

1. Une composition de revêtement à utiliser sur un substrat et comprenant un mélange optiquement limpide de deux ou de plus de deux polymères avec un dérivé photosensible qui libère un acide fort par exposition suivant une image à une radiation actinique, caractérisée en ce que la composition du mélange comprend:
(a) au moins un premier polymère qui est collant du fait que sa température de transition vitreuse T_{g} est inférieure à la température ambiante;
(b) au moins un second polymère dont la T_{g} est suffisamment supérieure à la température ambiante pour que le mélange du premier et du ou des second(s) polymère(s) ne soit pas collant à la température ambiante;
(c) un composant qui libère un acide par exposition à une radiation actinique; et en ce que
(d) le ou lesdits second(s) polymère(s) renferme(nt) des groupes fonctionnels qui sont sensibles à des quantités catalytiques d'un acide de telle sorte que la réaction des groupes fonctionnels en présence de l'acide conduise à un polymère renfermant des groupes acides carboxyliques ou des groupes phénoliques, ledit polymère ainsi obtenu étant non miscible avec le polymère collant du mélange.

2. Une composition selon la revendication 1, dans laquelle le premier polymère collant est le poly(2-phényléthyl acrylate) ou le poly(3-phényl-1-propyl acrylate).

3. Une composition selon la revendication 2, dans laquelle le premier polymère collant est le poly(2-phényléthyl acrylate).

4. Une composition selon la revendication 2, dans laquelle le premier polymère collant est le poly(3-phényl-1-propyl acrylate).

5. Une composition selon la revendication 1, dans laquelle le poids moléculaire du ou des premiers polymères collants est inférieur à 30 000 g/mole.

6. Une composition selon la revendication 1, dans laquelle le groupe instable aux acides du ou des second(s) polymère(s) de T_{g} élevée est choisi parmi les ester d'acétal, ester t-butylique, dérivé t-butoxy-carbonyloxy d'un phénol et éther acétalique d'un phénol.

7. Une composition selon la revendication 1, dans laquelle le ou les seconds polymères instables aux acides est (sont) choisis parmi poly(tétrahydro-2-pyranyl méthacrylate) et poly(tétrahydro-2-pyranyl acrylate).

8. Une composition selon la revendication 1, dans laquelle le poids moléculaire du ou des second(s) polymère(s) instable(s) aux acides est inférieur à 30 000 g/mole.

9. Une composition selon la revendication 1, dans laquelle les polymères sont préparés par un procédé choisi parmi polymérisation d'addition, polymérisation de condensation et polymérisation avec ouverture de cycle.

10. Une composition selon la revendication 1, dans laquelle la T_{g} du mélange est supérieure à celle du ou des premiers polymères collants et inférieure à celle du ou des seconds polymères labiles aux acides.

11. Une composition selon la revendication 1, dans laquelle le composant libérant l'acide est choisi parmi les sels de diazonium, phosphonium, sulfonium et iodonium, dérivés halogénés, sulfochlorure de o-quinone diazodure, associations organométallique/organohalogéné et esters o-nitrobenzylique d'acides forts.

12. Une composition selon la revendication 1, dans laquelle le composant libérant l'acide est l'hexafluoroantimoniate de diphényl-3-(9-anthryl)-1-propylsulfonium.

13. La composition selon la revendication 1, dans un solvant choisi parmi 2-butanone, acétone, chlorure de méthylène, tétrahydrofuranne et acétate d'éthyle.

14. Un élément sensible aux radiations comprenant un support portant une couche d'une composition selon l'une quelconque des revendications 1 à 12.

15. L'élément selon la revendication 14, dans lequel le support est choisi parmi papier, carton, feuilles métalliques, bois, verre, films ou nappes de fibres de polymères naturels et films ou nappes de fibres de polymères synthétiques.

16. L'élément selon la revendication 14, dans lequel une couche supplémentaire non photosensible est appliquée sur le support.

17. L'élément selon la revendication 14, dans lequel la couche supplémentaire non photosensible est une couche anti-halo disposée en-dessous de la couche photosensible.

18. Un procédé de création d'une surface pouvant retenir du toner comprenant l'étape d'irradiation d'un élément selon une quelconque des revendications 14 à 17 pour libérer un acide qui conduit à l'obtention d'une surface collante pouvant recevoir du toner.

19. Le procédé selon la revendication 18, dans lequel la surface collante pouvant recevoir du toner est développée à l'aide de particules de toner qui adhèrent sur la surface collante.
